**Europäisches Patentamt**

**European Patent Office**

**Office européen des brevets**

(19)

(11) Numéro de publication : **0 437 404 B1**

## (12) FASCICULE DE BREVET EUROPEEN

(45) Date de publication du fascicule du brevet :
**23.03.94 Bulletin 94/12**

(51) Int. Cl.$^5$ : **G01J 4/04**

(21) Numéro de dépôt : **91400051.8**

(22) Date de dépôt : **11.01.91**

(54) **Capteur de détection et de mesure de l'angle de rotation d'un plan de polarisation de la lumière.**

(30) Priorité : **12.01.90 FR 9000318**

(43) Date de publication de la demande :
**17.07.91 Bulletin 91/29**

(45) Mention de la délivrance du brevet :
**23.03.94 Bulletin 94/12**

(84) Etats contractants désignés :
**AT BE CH DE DK ES FR GB GR IT LI LU NL SE**

(56) Documents cités :
**DE-A- 2 618 953**
**DE-A- 2 854 064**
**DE-B- 1 189 758**
**US-A- 3 520 617**

(73) Titulaire : **BERTIN & CIE**
**Zone Industrielle Boîte postale 3**
**F-78373 Plaisir Cédex (FR)**

(72) Inventeur : **Lequime, Michel**
**6, Rue des Sauries**
**F-13510 Eguilles (FR)**

(74) Mandataire : **Ramey, Daniel et al**
**Cabinet Ores 6 Avenue de Messine**
**F-75008 Paris (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

EP 0 437 404 B1

## Description

L'invention concerne un capteur de détection et de mesure de l'angle de rotation d'un plan de polarisation de la lumière, comprenant un élément optique polarisant soumis à une influence extérieure provoquant une rotation du plan de polarisation délivré par cet élément, comme décrit par exemple dans le document DE-A-2 854 064.

On connaît déjà des capteurs de détection et de mesure de grandeurs physiques telles que la température ou un déplacement, qui sont du type à codage par modulation spectrale de la lumière et qui comprennent, pour l'essentiel, un polariseur, un cristal biréfringent soumis à la grandeur physique à mesurer, et un analyseur, ces capteurs étant reliés par des fibres optiques, d'une part à une source de lumière incohérente, d'autre part à un appareil d'analyse spectrale de la lumière, comprenant en général un interféromètre démodulateur. Dans ces capteurs, le spectre de la lumière fournie par la fibre optique est modulé périodiquement à une fréquence qui est fonction de la différence de marche dans le cristal biréfringent, cette différence de marche étant elle-même fonction de la grandeur physique à mesurer.

De tels capteurs peuvent être utilisés dans des endroits très peu accessibles et/ou à environnement dangereux, et/ou situés à des distances relativement importantes de la source lumineuse et de l'appareil d'analyse de la lumière.

L'invention a essentiellement pour objet un capteur de détection et de mesure de l'angle de rotation d'un plan de polarisation de la lumière, offrant les mêmes avantages que les capteurs connus du type à modulation spectrale de la lumière.

Elle propose, à cet effet, un capteur de détection et de mesure de l'angle de rotation d'un plan de polarisation de la lumière, comprenant une source de lumière incohérente, une fibre optique reliant la source à un système optique polarisant soumis à une influence extérieure provoquant une rotation du plan de polarisation de la lumière délivrée par ce système, caractérisé en ce que ledit système est associé à un dispositif de modulation spectrale de la lumière, comprenant essentiellement un cristal biréfringent et un analyseur, et à une lame quart d'onde achromatique, placée en avant ou en arrière du cristal biréfringent.

Le capteur selon l'invention fournit un flux lumineux dont le spectre est modulé à une fréquence qui est fonction, d'une part de la différence de marche dans le cristal biréfringent et, d'autre part, de l'angle de rotation du plan de polarisation de la lumière délivrée par le système optique précité.

Une démodulation de ce flux lumineux permet donc de remonter à cet angle de rotation, la différence de marche dans le cristal biréfringent étant connue.

Le capteur selon l'invention peut fonctionner en transmission et est alors raccordé, à son extrémité opposée à la source de lumière, à un interféromètre démodulateur.

Il peut également fonctionner en réflexion, et son extrémité opposée à celle reliée à la source de lumière comprend un moyen optique de réflexion de préférence du type rétroréflecteur, l'analyseur précité étant placé entre le cristal biréfringent et ce moyen optique de réflexion.

Selon un mode de réalisation de ce capteur, le système optique précité est un polariseur associé à un élément magnéto-optique soumis à un champ magnétique.

Dans ce cas, le champ magnétique peut être déterminé par mesure de l'angle de rotation du plan de polarisation de la lumière délivrée par l'élément magnéto-optique. On peut également déterminer ainsi l'intensité d'un courant électrique qui produit ce champ magnétique.

En variante, le système précité peut être un simple polariseur monté rotatif autour de l'axe optique du capteur. Dans ce cas, on peut mesurer la position angulaire de ce polariseur, ou sa vitesse de rotation.

Selon une autre variante, et dans le cas d'un capteur fonctionnant en transmission, le système optique précité inclut un polariseur et un élément actif du type à polarisation rotatoire, tel par exemple qu'un cristal cholestérique, possédant un pouvoir rotatoire relativement élevé, qui est fonction de la température.

Quand le phénomène extérieur est du type à variation alternative, le capteur est raccordé à un appareil d'analyse comprenant un circuit d'amplification différentielle, un circuit analogique de calcul de phase et des filtres accordés respectivement sur une fréquence de base correspondant au double de la pulsation du phénomène extérieur et sur des harmoniques de cette fréquence de base.

L'invention sera mieux comprise et d'autres caractéristiques, détails et avantages de celle-ci apparaîtront plus clairement à la lecture de la description qui suit, faite en référence aux dessins annexés dans lesquels :

la figure 1 est une vue schématique d'un système de détection et de mesure comprenant un capteur selon l'invention ;

la figure 2 représente schématiquement les orientations relatives des divers éléments de ce capteur;

la figure 3 est une vue schématique d'une variante de réalisation du système de détection et de mesure et du capteur selon l'invention;

La figure 4 est une vue schématique d'une autre variante de réalisation du système selon l'invention.

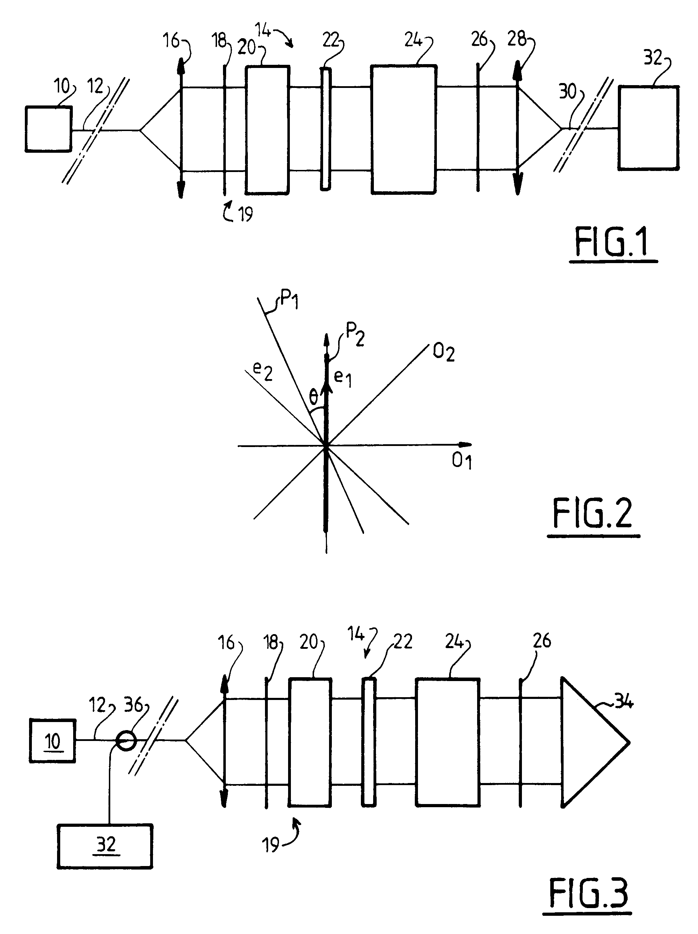

On se réfère d'abord à la figure 1, dans laquelle on a représenté schématiquement un exemple de réalisation d'un système de mesure comprenant un capteur selon l'invention, du type fonctionnant en transmission.

Ce système comprend une source 10 de lumière incohérente, reliée par une fibre optique 12 au capteur selon l'invention, désigné globalement par la référence 14.

Ce capteur est relié à la fibre optique 12 par une lentille de collimation 16, suivie d'un système de transduction 19, capable de produire un flux lumineux à polarisation rectiligne, l'orientation angulaire de ce plan de polarisation étant fonction du paramètre physique dont le système 19 assure la transduction.

A titre d'exemples, le système de transduction 19 peut :
- inclure un polariseur fixe 18 et un élément sensible de type magnéto-optique 20, pour la mesure d'un champ magnétique,
- se réduire à un simple polariseur tournant 18, pour une mesure d'angle ou de vitesse de rotation.

Le système 19 est suivi d'une lame quart d'onde achromatique 22, qui peut être placée en avant ou en arrière d'un cristal biréfringent 24. Un analyseur 26 est placé entre le cristal 24 et une lentille de collimation 28 reliant le capteur 14 à une fibre optique 30 menant à un appareil 32 d'analyse spectrale du flux lumineux délivré par le capteur.

Les orientations relatives des différents éléments du capteur 14 sont indiquées schématiquement en figure 2.

Les axes neutres o1, e1 de la lame quart d'onde 22 sont orientés à 45° des axes neutres o2, e2 du cristal biréfringent 24. La direction passante P2 de l'analyseur 26 est confondue avec l'un des axes neutres de la lame quart d'onde 22, tandis que le plan de polarisation de la lumière délivrée par le système 19 fait un angle $\theta$ avec la direction passante de l'analyseur 26.

Le flux lumineux délivré par le capteur 14 peut s'écrire sous la forme suivante :

$$P_c (\sigma) = T_c P_o (\sigma) [1 + \cos (2 \pi \sigma e \Delta n - 2 \theta)]$$

où =

$P_c (\sigma)$      = flux lumineux sortant du capteur

$P_o (\sigma)$      = flux lumineux délivré par la source 10,

$\sigma$      = nombre d'onde

$T_c$      = facteur de transmission du capteur

$e$      = épaisseur du cristal biréfringent 24

$\Delta n$      = différence des indices du cristal biréfringent 24

$\theta$      = position angulaire du plan de polarisation délivré par le système de transduction 19.

Quand le phénomène de transduction se limite à la rotation du polariseur 18, la mesure de la phase du signal à la fréquence utile renseigne sur la position angulaire de ce polariseur.

Quand l'élément sensible 20 est un élément magnéto-optique soumis à un champ magnétique H, ce champ est relié à l'angle de rotation $\theta$ du plan de polarisation induit par de l'élément 20 par la relation :

$$\theta = V L H$$

où :

     V est la constante de Verdet

     L est la longueur de l'élément 20.

La formule donnant le flux lumineux délivré par le capteur montre que la phase du signal lumineux est bien modulée par l'angle de rotation du plan de polarisation de la lumière, et que le capteur 14 constitue un transducteur du phénomène extérieur provoquant cette rotation.

Dans la variante de réalisation représentée en figure 3, le capteur 14 fonctionne en réflexion et comprend, à son extrémité opposée à celle qui est reliée à la source lumineuse 10, un élément réfléchissant 34 en avant duquel est placé l'analyseur 26. De préférence, cet élément 34 est du type rétroréflecteur, tel qu'un coin de cube. Pour le reste, la constitution du capteur est identique à celle du mode de réalisation de la figure 1, c'est-à-dire qu'il comprend une lentille de collimation 16 le reliant à la fibre optique 12, le système de transduction 19, la lame quart d'onde 22 et le cristal biréfringent 24.

Un coupleur en Y 36 est prévu sur la fibre optique 12 pour transmettre le signal fourni par le capteur 14 à l'appareil 32 d'analyse de la lumière.

Le flux lumineux fourni par le capteur 14 s'écrit sous la forme suivante :

$$P_c (\sigma) = \frac{3}{16} \cos^2 \delta \ T'_c \ P_o (\sigma) [ 1 + \frac{4}{3} \cos (2\pi\sigma e - 2 \theta) + \frac{1}{3} \cos 2 (2\pi\sigma e - 2\theta)]$$

où :

     $T'_c$ est le facteur de transmission du capteur traversé dans les deux sens,

     $\cos^2 \delta$ est un facteur d'affaiblissement dû à la traversée du réflecteur 34.

La mise en série des deux trajets aller et retour réalisée grâce à l'interposition de l'analyseur 26 placé devant l'élément réflecteur 34 est la seule méthode qui permette d'avoir accès au phénomène de transduction recherché dans un montage en réflexion. L'emploi d'un rétroréflecteur garantit en outre la qualité et la stabilité du rétrocouplage dans la fibre optique.

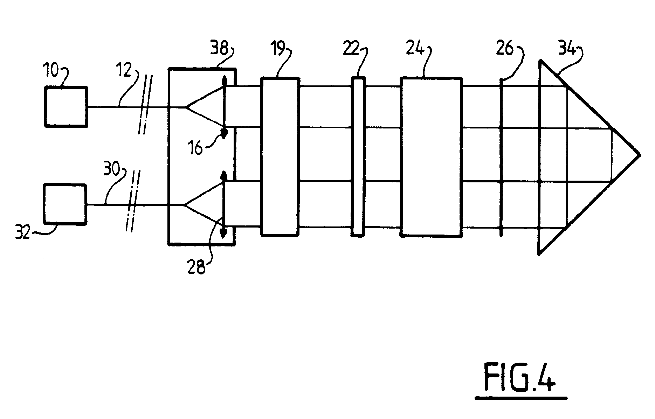

Une solution intermédiaire possible est représentée en Figure 4. Dans ce cas, les deux lentilles 16 et 28 sont montées côte à côte et solidaires d'un bâti mécanique unique 38, leurs axes optiques étant parallèles. Les fibres optiques 12 et 30 sont placées aux foyers de ces optiques de manière à ce qu'elles génèrent deux faisceaux de rayons également parallèles. L'élément rétroréflecteur 34 du type coin de cube, réalise le repliement et la translation du faisceau avec les caractéristiques de tolérances recherchées et analogues à celles du montage en réflexion. La proximité des ensembles 12, 16 et 30, 28 permet de mieux garantir leur stabilité relative que dans le cas d'un montage en transmission. Les éléments actifs 19, 22, 24 et 26 peuvent n'intercepter que l'un des faisceaux (fonctionnement du type transmission) ou les deux (fonctionnement du type réflexion).

Dans le cas où le phénomène analysé est de basse fréquence et correspond à la rotation directe du polariseur 18, une mesure à deux longueurs d'onde (fournies par deux sources différentes) à la fréquence de codage e n permet de remonter à deux informations distinctes, à savoir:

- d'une part $\dfrac{2\pi}{\lambda_1} e \Delta n - 2\theta = \Phi_1$

- d'autre part $\dfrac{2\pi}{\lambda_2} e \Delta n - 2\theta = \Phi_2$

Le calcul de la différence entre ces deux quantités permet d'évaluer les effets directement liés à la constitution du cristal de codage (dépendance thermique de la biréfringence notamment) et d'en tenir compte dans l'évaluation du paramètre :

$$\Phi_2 - \Phi_1 = \frac{2\pi}{\Lambda} e \Delta n \text{ avec } \Lambda = \frac{\lambda_1 \lambda_2}{\lambda_1 - \lambda_2}$$

($\Phi_2 - \Phi_1$ est indépendant de $\theta$ et permet de calculer e $\Delta$ n)

Cette méthode est également utilisable dans le cas d'une transduction de champ magnétique, mais de manière moins directe dans la mesure où la constante de VERDET d'une substance est, en première approximation, inversement proportionnelle au carré de la longueur d'onde.

Dans le cas où l'on a recours à un fonctionnement du type en réflexion, on dispose de 2 fréquences de modulation dont l'une est le double de l'autre, et cela peut être mis à profit pour s'affranchir des dérives éventuelles de la longueur d'onde centrale de la source 10.

En variante, lorsque le phénomène analysé est une rotation haute fréquence de l'analyseur 18, la mesure de la fréquence d'oscillation du signal renseigne directement sur la valeur de la fréquence de rotation de l'analyseur (à un facteur 2 près). Dans ce cas, les dérives éventuelles du cristal de codage ou de la longueur d'onde centrale de la source sont automatiquement éliminées car appartenant au domaine des basses fréquences (de l'ordre du Hertz ou moins).

Enfin, lorsque le phénomène extérieur (par exemple le champ magnétique) est du type à variation alternative ou sinusoïdale de pulsation déterminée, les signaux utiles fournis par le capteur et l'appareil d'analyse 32 sont analogues à ceux fournis par une démodulation pseudo-hétérodyne et pourront être traités de manière similaire au moyen de filtres accordés sur le double de la pulsation précitée et sur ses harmoniques.

## Revendications

1. Capteur de détection et de mesure de l'angle de rotation d'un plan de polarisation de la lumière, comprenant une source (10) de lumière incohérente, une fibre optique (12) reliant la source à un système optique polarisant (19) soumis à une influence extérieure provoquant une rotation du plan de polarisation de la lumière délivrée par ce système, caractérisé en ce que ledit système (19) est associé à un dispositif de modulation spectrale de la lumière, comprenant essentiellement un cristal biréfringent (24) et un analyseur (26), et à une lame quart d'onde (22) achromatique, placée en avant ou en arrière du cristal biréfringent (24).

2. Capteur selon la revendication 1, caractérisé en ce que les axes neutres (o1, e1) de la lame quart d'onde (22) sont orientés à 45° de ceux du cristal biréfringent (24).

3. Capteur selon la revendication 2, caractérisé en ce que la direction de polarisation (p2) de l'analyseur (26) précité est confondue avec l'un des axes neutres de la lame quart d'onde (22).

4. Capteur selon l'une des revendications précédentes, caractérisé en ce qu'il fonctionne en transmission et son extrémité opposée à celle raccordée à la source de lumière (10) est reliée par une fibre optique (30) à un appareil d'analyse (32) tel qu'un interféromètre démodulateur.

5. Capteur selon l'une des revendications 1 à 3, caractérisé en ce qu'il fonctionne en réflexion et son extrémité opposée à celle reliée à la source de lumière (10) comprend un moyen optique de réflexion (34), l'analyseur précité (26) étant placé entre le cristal biréfringent (24) et ce moyen optique de réflexion (34).

6. Capteur selon l'une des revendications précédentes, caractérisé en ce que le système (19) précité comprend un polariseur fixe (18) et un élément magnéto-optique (20) soumis à un champ magnétique.

7. Capteur selon l'une des revendications 1 à 5, caractérisé en ce que le système (19) précité est constitué d' un polariseur (18) monté rotatif autour de l'axe optique du capteur (14).

8. Capteur selon l'une des revendications 1 à 5, caractérisé en ce que le système (19) comprend un polariseur fixe (18) et un élément (20) à polarisation rotatoire, tel par exemple qu'un cristal cholestérique.

9. Capteur selon l'une des revendications 1 à 4, caractérisé en ce qu'il comprend deux lentilles de collimation (16, 28) d'axes parallèles, montées côte à côte dans un bâti commun (38) et dont l'une est raccordée par une fibre optique (12) à la source (10) et l'autre par une fibre optique (30) à un appareil d'analyse spectrale (32), le système optique (19), le cristal biréfringent (24), la lame quart d'onde (22) et l'analyseur (26) étant interposés entre l'une de ces lentilles et un moyen de réflexion optique (34) tel qu'un coin de cube par exemple.

10. Capteur selon l'une des revendications 1 à 9, caractérisé en ce que, dans le cas où le phénomène agissant sur le système optique (19) est de basse fréquence, le capteur est relié à un appareil d'analyse spectrale accordé sur la fréquence liée au cristal biréfringent (24) et est associé à des sources délivrant des flux lumineux centrés sur deux longueurs d'onde différentes $(\lambda_1, \lambda_2)$ .

11. Capteur selon l'une des revendications 1 à 9 caractérisé en ce que, quand le système optique (19) est constitué d'un polariseur (18) tournant à vitesse élevée, le capteur délivre un flux lumineux dont la fréquence d'oscillation correspond, à un facteur 2 près, à la fréquence de la rotation du polariseur tournant (18).

12. Capteur selon l'une des revendications 1 à 8 caractérisé en ce que, quand le phénomène agissant sur le système (19) précité est de type alternatif périodique, le capteur (14) est raccordé à un appareil d'analyse comprenant un circuit d'amplification différentielle, un circuit analogique de calcul de phase et des filtres accordés respectivement sur une fréquence de base correspondant au double de la pulsation du phénomène et sur des harmoniques de cette fréquence de base.

**Patentansprüche**

1. Sensor zum Feststellen und Messen der Drehung der Polarisationsebene von Licht, der folgendes aufweist: eine Quelle (10) von inkohärentem Licht, eine optische Faser (12), welche die Quelle mit einem polarisierenden optischen System (19) verbindet, das einem äußeren Einfluß unterliegt, welcher eine Drehung der Polarisationsebene des von diesem System gelieferten Lichtes hervorruft, **dadurch gekennzeichnet, daß** dieses System (19) einer Vorrichtung zur spektralen Modulation des Lichtes, die im wesentlichen einen doppelbrechenden Kristall (24) und einen Analysator (26) aufweist, und einem achromatischen Lambda-Viertel Plättchen (22) zugeordnet ist, welches vor oder hinter dem doppelbrechenden Kristall (24) angeordnet ist.

2. Sensor nach Anspruch 1, **dadurch gekennzeichnet, daß** die neutralen Achsen (o1, e1) des Lambda-Viertel Plättchens (22) bezüglich jener des doppelbrechenden Kristalls (24) unter 45° ausgerichtet sind.

3. Sensor nach Anspruch 2, **dadurch gekennzeichnet, daß** die Polarisationsrichtung (p2) des Analysators (26) mit einer neutralen Achse des Lambda-Viertel Plättchens (22) ausgerichtet ist.

4. Sensor nach einem der vorigen Ansprüche, **dadurch gekennzeichnet, daß** er in Transmission betrieben wird **und daß** sein Ende, das dem mit der Lichtquelle (10) verbundenen gegenüber liegt, mittels einer optischen Faser (30) mit einem Analysegerät (32), wie einem demodulierenden Interferometer, verbunden ist.

5. Sensor nach einem der Ansprüche 1 bis 3, **dadurch gekennzeichnet, daß** er in Reflexion betrieben wird **und daß** sein Ende, das dem mit der Lichtquelle (10) verbundenen gegenüber liegt, ein optisches Reflexionsmittel (34) aufweist, wobei der Analysator (26) zwischen dem doppeibrechenden Kristall (24) und diesem optischen Reflexionsmittel (34) angeordnet ist.

6. Sensor nach einem der vorigen Ansprüche, **dadurch gekennzeichnet, daß** das System (19) einen festen Polarisator (18) und ein magneto-optisches Element (20) aufweist, das einem Magnetfeld ausgesetzt ist.

7. Sensor nach einem der Ansprüche 1 bis 5, **dadurch gekennzeichnet, daß** das System (19) aus einem um die optische Achse des Sensors (14) drehbar angeordneten Polarisator (18) besteht.

8. Sensor nach einem der Ansprüche 1 bis 5, **dadurch gekennzeichnet, daß** das System (19) einen festen Polarisator (18) und ein zirkular polarisierendes Element (20), beispielsweise einen cholesterischen Kristall, aufweist.

9. Sensor nach einem der Ansprüche 1 bis 4, **dadurch gekennzeichnet, daß** er zwei Kollimationslinsen (16, 28) mit parallelen Achsen aufweist, die Seite an Seite an einem gemeinsamen Träger (38) befestigt sind und von denen eine mittels einer optischen Faser (12) mit der Quelle (10) und die andere mittels einer optischen Faser (30) mit einem Spektralanalysegerät (32) verbunden ist, wobei das optische System (19), der doppelbrechende Kristall (24), das Lambda-Viertel Plättchen (22) und der Analysator (26) zwischen einer dieser Linsen und einem optischen Reflexionsmittel (34), wie beispielsweise einem Prisma, angeordnet sind.

10. Sensor nach einem der Ansprüche 1 bis 9, **dadurch gekennzeichnet, daß,** falls auf das optische System (19) ein Phänomen mit niedriger Frequenz einwirkt, der Sensor mit einem auf die Frequenz des doppelbrechenden Kristalls (24) abgestimmten Spektralanalysegerät verbunden und Quellen zugeordnet ist, die Lichtflüsse aussenden, welche zwischen zwei unterschiedlichen Wellenlängen ($\lambda_1$, $\lambda_2$) liegen.

11. Sensor nach einem der Ansprüche 1 bis 9, **dadurch gekennzeichnet, daß,** wenn das optische System (19) aus einem mit hoher Geschwindigkeit rotierenden Polarisator (18) besteht, der Sensor einen Lichtfluß liefert, dessen Schwingungsfrequenz, im Bereich eines Faktors zwei, der Rotationsfrequenz des rotierenden Polarisators (18) entspricht.

12. Sensor nach einem der Ansprüche 1 bis 8, **dadurch gekennzeichnet, daß,** wenn auf das System (19) ein alternierend periodisches Phänomen einwirkt, der Sensor (14) an ein Analysegerät angeschlossen ist, welches eine Differenzenverstärkerschaltung, eine analoge Phasenberechnungsschaltung und Filter enthält, die auf eine Grundfrequenz, welche dem Doppelten der Pulsation des Phänomens entspricht, und auf die Harmonischen dieser Grundfrequenz abgestimmt sind.

## Claims

1. A sensor for detecting and measuring the angle of rotation of a plane of light polarization, the sensor comprising a source (10) of incoherent light, an optical fiber (12) connecting the source to a polarizing optical system (19) subjected to an external influence that causes a rotation in the plane of polarization of the light delivered by the system, the sensor being characterized in that said system (19) is associated with a light spectrum modulator device essentially comprising a birefringent crystal (24) and an analyzer (26), and with an achromatic quarterwave plate (22) placed before or after the birefringent crystal (24).

2. A sensor according to claim 1, characterized in that the neutral axes ol and el of the quarterwave plate (22) are oriented at 45° to the neutral axes of the birefringent crystal (24).

3. A sensor according to claim 2, characterized in that the polarization direction (p2) of the above-mentioned analyzer (26) coincides with one of the neutral axes of the quarterwave plate (22).

4. A sensor according to any preceding claim, characterized in that it operates in transmission and its end opposite to its end connected to the light source (10) is connected via an optical fiber (30) to an analyzer apparatus (32) such as a demodulator interferometer.

5. A sensor according to any one of claims 1 to 3, characterized in that it operates in reflection, and its end opposite to its end connected to the light source (10) includes optical reflection means (34), the above-mentioned analyzer (26) being placed between the birefringent crystal (24) and said optical reflection means (34).

6. A sensor according to any preceding claim, characterized in that the above-mentioned system comprises a stationary polarizer (18) and a magneto-optical component (20) subjected to a magnetic field.

7. A sensor according to any one of claims 1 to 5, characterized in that the above-mentioned system (19) is constituted by a polarizer (18) mounted to rotate about the optical axis of the sensor (14).

8. A sensor according to any one of claims 1 to 5, characterized in that the system (19) comprises a stationary polarizer (18) and a component (20) having rotatory polarization, such as a cholesteric crystal, for example.

9. A sensor according to any one of claims 1 to 4, characterized in that it comprises two parallel-axis collimator lenses (16, 28) mounted side by side in a common frame (38), one of which is connected via an optical fiber (12) to the source (10) and the other of which is connected via an optical fiber (30) to a spectrum analyzer apparatus (32), the optical system (19), the birefringent crystal (24), the quarterwave plate (22), and the analyzer (26) all being interposed between one of said lenses and optical reflection means (34) such as a corner of a cube, for example.

10. A sensor according to any one of claims 1 to 9, characterized in that when the phenomenon acting on the optical system (19) is a low frequency phenomenon, the sensor is connected to a spectrum analyzer apparatus tuned to the frequency related to the birefringent crystal (24) and is associated with sources that deliver light fluxes centered on two different wavelengths ($\lambda_1$, $\lambda_2$).

11. A sensor according to any one of claims 1 to 9, characterized in that when the optical system (19) is constituted by a polarizer (19) rotating at high speed, the sensor delivers a light flux whose frequency of oscillation corresponds to within a factor of two to the frequency of rotation of the rotating polarizer (18).

12. A sensor according to any one of claims 1 to 8, characterized in that when the phenomenon acting on the above-mentioned system (19) is of the periodically alternating type, the sensor (14) is connected to an analyzer apparatus comprising a differential amplifier circuit, an analog phase calculation circuit, and filters tuned respectively to a low frequency corresponding to twice the angular frequency of the phenomenon and to harmonics of said low frequency.

FIG.1

FIG.2

FIG.3

FIG.4